# EUROPÄISCHE PATENTSCHRIFT

(11) **EP 0 788 030 B1**
(45) Veröffentlichungstag und Bekanntmachung des Hinweises auf die Patenterteilung: **21.03.2001**
(21) Anmeldenummer: 97101556.5
(22) Anmeldetag: 31.01.1997
(51) Int. Cl.: G03F 3/10

(54) **Trägermaterial für Farbprüfbilder**
Support for colour proof
Support pour épreuve en couleurs

(30) Priorität: 05.02.1996 DE 19603852
(43) Veröffentlichungstag der Anmeldung: 06.08.1997
(73) Patentinhaber: SCHOELLER TECHNICAL PAPERS, INC, Pulaski New York 13142-0250 (US)
(72) Erfinder: Simpson, Steve, Victor, New York 14564 (US)
(74) Vertreter: Cohausz & Florack

(56) Entgegenhaltungen:
- EP-A- 0 183 467
- EP-A- 0 723 200
- US-A- 4 262 071
- S. OHARA, N MORIMOTO: "Laminates for Paper Containers" ABSTRACT BULLETIN OF THE INSTITUTE OF PAPER CHEMISTRY, Bd. 57, Nr. 10, April 1987, APPLETON, WISCONSIN, USA, Seite 1460 XP002049213
- SAECHTLING-ZEBROWSKI: "Kunststoff Taschenbuch", 1965, CARL HANSER, MUNICH

## Beschreibung

Die vorliegende Erfindung betrifft ein Trägermaterial für Farbprüfbilder für die graphische Industrie.

In der Reproduktionstechnik werden gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren (Color proofing) daraufhin überprüft, ob das spätere Druckergebnis eine tonwertrichtige Reproduktion der Vorlage darstellt.

In solchen Farbprüfverfahren finden beispielsweise strahlungsempfindliche Aufzeichnungsmaterialien Verwendung, bei denen zur Bilderzeugung Unterschiede in der Klebrigkeit der belichteten und unbelichteten Bereiche der strahlungsempfindlichen Schicht ausgenutzt werden. Das latente Bild wird dann durch das Aufbringen geeigneter Toner sichtbar gemacht, die nur an den unbelichteten klebrigen Stellen haften. Nach diesem Verfahren werden positive Bilder der Vorlage erhalten, die im Aussehen den unter Verwendung von Druckfarben hergestellten Bildern gleichen.

Nach einer anderen Methode kann der auf einem Träger befindliche Toner (Farbfolien) durch Inkontaktbringen mit der bildmäßig belichteten Schicht übertragen werden.

Die strahlungsempfindlichen Aufzeichnungsmaterialien bestehen üblicherweise aus einem Schichtträger, einer strahlungsempfindlichen Schicht und einer Deckfolie. Diese Deckfolie wird abgezogen und das Material auf ein Bildträgermaterial auflaminiert, bevor die bildmäßige Belichtung erfolgt.

Als Bildträgermaterial zur Herstellung von Prüfdrucken werden üblicherweise harzbeschichtete oder gestrichene Papiere (z.B. das sog. "Kromkote®-Papier") eingesetzt.

Bekannt ist beispielsweise ein Bildträger, bestehend aus einem Papiersubstrat, dessen bildtragende Vorderseite eine Polyethylenschicht und eine mit ihr fest verbundene acrylhaltige weitere Schicht enthält.

Nachteilig an den bekannten Bildträgern ist, daß sie im Laminiervorgang zur Bildung von lufthaltigen Mikrobläschen in den auf die Bildträger aufzutragenden, Farbmittel ragenden Schichten führen und somit den späteren Farbeindruck verfälschen.

Aus der EP 0 183 467 A1 ist ein Bildträgermaterial bekannt, das aus einer auf einer Seite eines Basispapiers angeordneten Polyolefinschicht mit einer darauf angeordneten weichen Polymerschicht, beispielsweise ein Ethylen/Vinylacetat-Copolymer, und einer weiteren, auf der weichen Polymerschicht angeordneten härteren Polymerschicht besteht. Dieses Bildträgermaterial ist ein Fotobasispapier, auf das die fotografische Emulsion noch aufzutragen ist.

Die Aufgabe der vorliegenden Erfindung ist es, ein Bildträgermaterial für Farbprüfbilder zur Verfügung zustellen, das den oben beschriebenen Nachteil nicht aufweist. Darüber hinaus ist es Aufgabe der vorliegenden Erfindung, den Laminiervorgang bei niedrigeren Temperaturen und erhöhten Drücken durchführen zu können, um eine Verbesserung der Laminierungsqualität und eine Erhöhung der Produktivität zu erreichen.

Die Aufgabe wird durch ein Bildträgermaterial für Farbprüfbilder mit einer mindestens auf einer Seite eines Basispapiers angeordneten Polyolefinschicht und gegebenenfalls weiteren Schichten gelöst, das sich dadurch auszeichnet, daß es zusätzlich auf der bildseitigen Polyolefinschicht eine ein weiches Polymer mit einem Schmelzindex von 2 bis 10 dg/min (gemäß ASTM D 1238) enthaltende Schicht A und eine weitere, ein härteres Polymer enthaltende Schicht B enthält, wobei das härtere Polymer ein Acryl-Homo- und/oder -Copolymer mit einer Shore-Härte (D) von > 50 (ASTM D 2240) ist.

Polymere mit einem Schmelzindex von 6 bis 8 dg/min werden vorzugsweise eingesetzt.

Das in der Schicht A enthaltene Polymer weist bevorzugt eine Shore-Härte (D) von 30 bis 50 auf (ASTM D 2240).

In einer bevorzugten Ausführungsform der Erfindung ist das Polymere der Schicht A ein Ehtylen/Vinylacetat-Copolymer. Besonders geeignet sind Ethylen/Vinylacetat-Copolymere mit einem Vinylacetat-Anteil von 10 bis 30 Mol%, insbesondere jedoch 12 bis 18 Mol%.
Aber auch andere Ehtylen-Copolymere können eingesetzt werden.

Das Auftragsgewicht der Schicht A beträgt 10 bis 30 g/m², insbesondere 15 bis 25 g/m².

Das in der Schicht B eingesetzte Polymer ist härter als das in der Schicht A eingesetzte. Es weist eine Shore-Härte (D) > 50 auf (ASTM D 2240). Besonders geeignet ist ein Acryl-Homo- und/oder -Copolymer vom Typ Neocryl®.
Das Auftragsgewicht der Schicht B beträgt 1 bis 8 g/m², insbesondere 2 bis 6 g/m².

Die bildseitige Polyolefinschicht ist eine auf der bildtragenden Vorderseite des Papiersubstrats (Basispapier) befindliche Polyolefinschicht, die vorzugsweise LDPE (Polyethylen niederer Dichte) und/oder HDPE (Polyethylen hoher Dichte) enthält. In einer bevorzugten Ausführungsform enthält die bildseitige Polyolefinschicht ein Weißpigment, beispielsweise TiO₂. Der Pigmentgehalt kann 5 bis 20 Gew.% betragen. Die Rückseite des Basispapiers weist in einer bevorzugten Ausführungsform ebenfalls eine Polyolefinschicht auf. Besonders geeignet ist hierfür ein LDPE und/oder HDPE. Diese Schicht kann zusätzlich Weißpigmente enthalten, beispielsweise TiO₂. Der Pigmentgehalt kann 5 bis 20 Gew.% betragen. Beide Polyolefinschichten werden in einem Extrusionsverfahren auf das Basispapier aufgetragen. Als Basispapier eignet sich ein sauer - oder neutralgeleimtes Papier mit einem Flächengewicht von 80 bis 300 g/m². Aber auch ein Papier mit Mischleimung kann eingesetzt werden.

Das Auiftragsgwicht der bildseitigen Polyolefinschicht beträgt 10 bis 40 g/m², insbesondere 10 bis 20 g/m². Das Auftragsgewicht der rückseitigen Polyolefinschicht beträgt 5 bis 45 g/m², insbesondere 5 bis 15 g/m².

| | |
|---|---|
| **Beispiel** | |
| B | Acryl-Copolymer (evtl. TiO₂) 2-6 g/m2 (z.B. 4 g/m²) |
| A | Ethylen/Vinylacetat (evtl. TiO₂) 15-25 g/m² (z.B. 20 g/m²) |
| | LDPE (evtl. 5-20% TiO₂) 10-20 g/m2 (z.B. 15 g/m²) |
| | Basispapier 80-300 g/m2 (z.B. 190 g/m²) |
| | HDPE (evtl. 5-20% TiO₂) 5-15 g/m² (z.B. 10 g/m²) |

Schicht A wurde mittels Extrusionsbeschichtung aufgetragen Schicht B wurde aus einer wäßr. Lösung aufgetragen

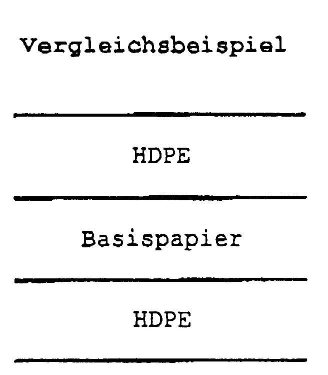

## Patentansprüche

1. Bildträgermaterial für Farbprüfbilder mit einer mindestens auf einer Seite eines Basispapiers angeordneten Polyolefinschicht und gegebenenfalls weiteren Schichten, **dadurch gekennzeichnet**, daß es zusätzlich auf der bildseitigen Polyolefinschicht eine ein weiches Polymer mit einem Schmelzindex von 2 bis 10 dg/min (gemäß ASTM D 1238) enthaltende Schicht A und eine weitere, ein härteres Polymer enthaltende Schicht B enthält, wobei das härtere Polymer ein Acryl-Homo- und/oder -Copolymer mit einer Shore-Härte (D) von > 50 (ASTM D 2240) ist.

2. Bildträgermaterial nach Anspruch 1, **dadurch gekennzeichnet**, daß das Polymer der Schicht A ein Ethylen/ Vinylacetat-Copolymer ist.

3. Bildträgermaterial nach Anspruch 2, **dadurch gekennzeichnet**, daß das Ethylen/Vinylacetat 10 bis 30 Mol% Vinylacetat enthält.

4. Bildträgermaterial nach einem der Ansprüche 1 bis 3, **dadurch gekennzeichnet**, daß die bildseitige Polyolefinschicht ein LDPE und/oder HDPE enthält.

5. Bildträgermaterial nach einem der Ansprüche 1 bis 4, **dadurch gekennzeichnet**, daß eine rückseitige Polyolefinschicht ein LDPE und/oder HDPE enthält.

6. Bildträgermaterial nach einem der Ansprüche 1 bis 5, **dadurch gekennzeichnet**, daß die Schicht A ein Weißpigment enthält.

7. Bildträgermaterial nach einem der Ansprüche 1 bis 6, **dadurch gekennzeichnet**, daß die Schicht B ein Weißpigment enthält.

## Claims

1. An image support material for color proofing images having a polyolefin layer coated at least on one side of a base paper and optionally further layers, characterised in that it additionally includes on the image-side polyolefin layer a layer A containing a soft polymer with a melt index of 2 to 10 dg/min (in accordance with ASTM D 1238) and a further layer B containing a harder polymer, whereby the harder polymer is an acryl homo- and/or copolymer with a shore-hardness (D) of > 50 (ASTM D 2240).

2. An image support material according to claim 1, characterised in that the polymer of the layer A is an ethylene/vinyl acetate copolymer.

3. An image support material according to claim 2, characterised in that the ethylene/vinyl acetate contains 10 to 30 mol% of vinyl acetate.

4. An image support material according to claims 1 to 3, characterised in that the image-side polyolefin layer contains an LDPE and/or HDPE.

5. An image support material according to claims 1 to 4, characterised in that the polyolefin layer on the rear side contains an LDPE and/or HDPE.

6. An image support layer according to claims 1 to 5, characterised in that the layer A contains a white pigment.

7. An image support layer according to claims 1 to 6, characterised in that the layer B contains a white pigment.

## Revendications

1. Matériau support d'image pour épreuves en couleurs avec une couche en polyoléfine disposée sur au moins une face d'un papier de base et facultativement, d'autres couches, qui est caractérisé en ce qu'il contient en outre, sur la couche en polyoléfine du côté de l'image, une couche A contenant un polymère mou avec un indice de fusion allant de 2 à 10 dg/minute (suivant ASTM D 1238) et une autre couche B contenant un polymère plus dur, où le polymère plus dur est un homo- et/ou copolymère acrylique avec une dureté Shore (D) > 50 (ASTM D 2240).

2. Matériau support d'image suivant la revendication 1, caractérisé en ce que le polymère de la couche A est un copolymère éthylène/acétate de vinyle.

3. Matériau support d'image suivant la revendication 2, caractérisé en ce que l'éthylène/ acétate de vinyle contient 10 à 30% en moles d'acétate de vinyle.

4. Matériau support d'image suivant l'une quelconque dès revendications 1 à 3, caractérisé en ce que la couche en polyoléfine du côté de l'image contient un LDPE et/ou un HDPE.

5. Matériau support d'image suivant l'une quelconque des revendications 1 à 4, caractérisé en ce qu'une couche en polyoléfine du verso contient un LDPE et/ou un HDPE.

6. Matériau support d'image suivant l'une quelconque des revendications 1 à 5, caractérisé en ce que la couche A contient un pigment blanc.

7. Matériau support d'image suivant l'une quelconque des revendications 1 à 6, caractérisé en ce que la couche B contient un pigment blanc.
